# EUROPEAN PATENT APPLICATION

(11) **EP 4 654 479 A1**
(43) Date of publication of application: **26.11.2025**
(21) Application number: 24176849.8
(22) Date of filing: 20.05.2024
(51) Int. Cl.: H03K 17/284, H01H 47/32, H02J 1/00, H03K 17/06

(54) **A SWITCHING APPARATUS FOR DC ELECTRIC GRIDS**

(71) Applicant: ABB Schweiz AG, 5400 Baden (CH)
(72) Inventor: Strassel, Thorsten, 5243 Mülligen (CH); Bianchetti, Romeo Alessandro, 8050 Zürich (CH); Abplanalp, Markus Andreas, 5405 Baden-Dättwil (CH); Corfdir, Pierre, 5430 Wettingen (CH); Suetterlin, Ralf-Patrick, 5400 Baden (CH)
(74) Representative: De Bortoli, Eros

(57) **Abstract**

A switching apparatus for DC electric grids comprising:
- first and second electric terminals for electrical connection with corresponding conductors of an electric line;
- a primary switching arrangement including one or more primary switching devices configured to conduct or block a current along a conductive path between said first and second electric terminals;
- a control stage including a control unit configured to control one or more controllable components of said switching apparatus;
- a power supply stage electrically connected to said control stage to feed said control stage with electric power drawn from said electric line;
- a secondary switching arrangement including one or more secondary switching devices controllable by the control stage. Said secondary switching devices are configured to electrically connect the power supply stage with said first electric terminals or with said second electric terminals, according to the needs.

## Description

The present invention relates to the field of electric grids. More particularly, the present invention relates to a switching apparatus for DC electric grids.

DC electric grids are widely adopted in a variety of applications, such as photovoltaic systems, naval systems, energy storage systems employing batteries (BESS), and the like.

As is known, when a fault event (such as an overload or a short-circuit) occurs in a DC electric line, many electrical components electrically connected to the electric line can potentially feed such an electric fault. Obviously, this may lead to catastrophic consequences, particularly when electric power generation systems (e.g. photovoltaic panels) or electric energy storage systems (e.g. batteries) are installed in the electric grid.

To prevent these undesired events, a DC electric grid normally comprises switching apparatuses to allow a selective disconnection of portions of electric grid, when a fault event occurs.

Some switching apparatuses of the state of the art include electromechanical circuit breakers. In general, these switching devices have the advantage of ensuring a galvanic isolation between the disconnected grid portions. Additionally, they are relatively cheap to realize at industrial level.

Many switching apparatuses of the state of the art, however, include switching devices of solid-state type, which include switches based on semiconductor materials. The main advantage of these switching devices resides in that they potentially have unlimited electrical endurance due to their arc-less switching operation. Further, they are fast operating and have an interruption time remarkably shorter in comparison with the electro-mechanical switching devices.

Many switching apparatuses employed in DC electric grids, particularly those including switching devices of solid-state type, are equipped with a control unit to control the operation of the controllable components installed on board, for example the above-mentioned semiconductor-based switches.

Typically, the control unit is "*self-powered*" in the sense that the switching apparatus includes a power supply stage configured to feed the control stage by drawing electric power directly from the electric line on which it is installed.

Normally, such a power supply stage is electrically connected to a power source side of the electric line in such a way to be able to feed the control stage as soon as the electric line is powered, even if the switching apparatus is still in an open state and no current flows along the electric line ("*black start*")*.*

Switching apparatuses of the state of the art, which employ self-powered control stages, have some aspects to improve.

The experience has shown how, during an opening manoeuvre of the switching apparatus, the above-mentioned power supply stage is often subject to in-rush currents. These undesired events occur as the input capacitance of the power supply stage substantially acts as a short-circuit during the initial stages of the opening manoeuvre.

The power supply stage (particularly input capacitor thereof) has thus to be properly sized to withstand these high energy phenomena and avoid damages to the input capacitance. This circumstance obviously entails relatively high industrial costs for manufacturing the power supply stage at industrial level. Additionally, the arrangement of a bulky input capacitor in the power supply stage may remarkably limit the current breaking performances of the switching devices intended to interrupt the electric current flowing along an electric line.

The main aim of the present invention is to provide a switching apparatus for DC electric grids, which allows overcoming or mitigating the above-mentioned criticalities.

More in particular, an object of the present invention is to provide a switching apparatus, in which a cheaper and lower-size power supply stage, possibly including a lower input capacitance, can be employed with respect to corresponding solutions of the state of the art. Another object of the present invention is to provide a switching apparatus ensuring performant interruption ratings, particularly in case of electric faults, for example in presence of short-circuits.

Yet a further object of the present invention is to provide a switching apparatus, which can be easily manufactured at industrial level, at competitive costs with respect to the solutions of the state of the art.

In order to fulfill these aims and objects, the present invention provides a switching apparatus, according to the following claim 1 and the related dependent claims.

The switching apparatus, according to the invention, comprises:
- first and second electric terminals for electrical connection with corresponding conductors of an electric line;
- a primary switching arrangement including one or more primary switching devices. The primary switching devices are configured to switch reversibly between a conduction state, at which said primary switching devices conduct a current along a conductive path between said first and second electric terminals, and an interdiction state, at which said primary switching devices block a current between said first and second electric terminals;
- a control stage including a control unit configured to control one or more controllable components of said switching apparatus;
- a power supply stage electrically connected to said control stage to feed said control stage with electric power drawn from said electric line.

According to the invention, the switching apparatus comprises a secondary switching arrangement including one or more secondary switching devices controllable by said control unit.

The secondary switching devices are configured to switch reversibly between a first switching condition, at which said secondary switching devices electrically connect said first electric terminals to the power supply stage and electrically disconnect said second electric terminals from the power supply stage, and a second switching condition, at which said secondary switching devices electrically disconnect the first electric terminals from the power supply stage and electrically connect the second electric terminals to the power supply stage.

According to an aspect of the invention, the control unit is configured to command the secondary switching devices to operate depending on the operating state of the switching apparatus.

Preferably, the control unit is configured to:
- command said secondary switching devices to operate in said first switching condition, when said switching apparatus is in an open state; and
- command said secondary switching devices to operate in said second switching condition, when said switching apparatus is in a closed state;
if said first electric terminals are electrically connected to a power source section of said electric line and said second electric terminals are electrically connected to a load section of said electric line.

Preferably, the control unit is configured to:
- command said secondary switching devices to operate in said second switching condition, when said switching apparatus is in an open state;
- command said secondary switching devices to operate in said first switching condition, when said switching apparatus is in a closed state;
if said first electric terminals are electrically connected to a load section of said electric line and said second electric terminals are electrically connected to a power source section of said electric line.

According to an aspect of the invention, the control unit is configured to command said secondary switching devices to switch reversibly between said first switching condition and said second switching condition during an opening manoeuvre or a closing manoeuvre of said switching apparatus.

Preferably, said control unit is configured to command said secondary switching devices to:
- switch from said first switching condition to said second switching condition before said primary switching devices carry out a switching transition corresponding to said closing manoeuvre;
- switch back from said second switching condition to said first switching condition, when said primary switching devices have completed the switching transition corresponding to said opening manoeuvre;
if said first electric terminals are electrically connected to a power source section of said electric line and said second electric terminals are electrically connected to a load section of said electric line.

Preferably, said control unit is configured to command said secondary switching devices to:
- switch from said second switching condition to said first switching condition before said primary switching devices carry out a switching transition corresponding to said closing manoeuvre;
- switch back from said first switching condition to said second switching condition, when said primary switching devices have completed the switching transition corresponding to said opening manoeuvre,
if said first electric terminals are electrically connected to a load section of said electric line and said second electric terminals are electrically connected to a power source section of said electric line.

According to some embodiments of the invention, the primary switching devices of the switching apparatus are of solid-state type and include each one or more switches based on semiconductor materials.

According to some embodiments of the invention, the primary switching devices are of electromechanical type.

According to some embodiments of the invention, the secondary switching devices are of electromechanical type.

According to some embodiments of the invention, the secondary switching devices are of solid-state type and include each one or more switches based on semiconductor materials. According to some embodiments of the invention, the secondary switching devices are of hybrid type. In this case, each secondary switching device includes one or more switches based on semiconductor materials and one or more electromechanical switches.

Further characteristics and advantages of the invention will emerge from the description of preferred, but not exclusive embodiments of the switching apparatus, according to the invention, non-limiting examples of which are provided in the attached drawings, wherein:

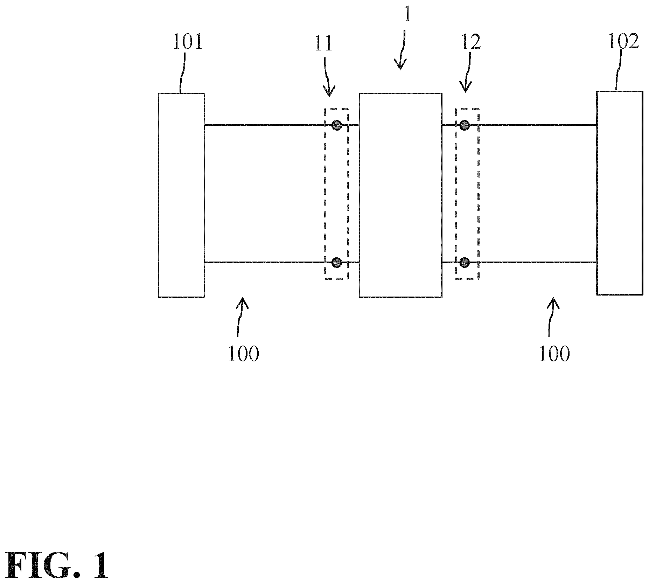

- Figure 1 schematically shows an electric line including the switching apparatus, according to the invention;
- Figure 2-3 schematically show different embodiments of the switching apparatus, according to the invention;
- Figure 3A-3B schematically show the switching apparatus, according to the invention, in different operating conditions;
- Figure 4A-4B schematically show a primary switching device of the switching apparatus, according to different embodiments of the invention;
- Figure 5-8 schematically show some control logics implemented by a control unit of the switching apparatus according to the invention.

With reference to the cited figures, the present invention relates to a switching apparatus 1 for DC electric grids.

The switching apparatus of the invention is particularly suitable for use in low-voltage DC electric grids, and it will be described hereinafter with reference to these applications for the sake of brevity only, without intending to limit the scope of the invention in any way. The switching apparatus of the invention may, in fact, be successfully used in electric systems of different type, such as medium-voltage DC electric grids.

For exemplary purposes, the term "low-voltage" (LV) typically relates to operating voltages lower than 1,5 kV AC and 2.0 kV DC whereas the term "medium-voltage" (MV) normally relates to higher operating voltages up to some tens of kV, e.g. up to 72 kV AC and 100 kV DC.

The switching apparatus 1 comprises first and second electric terminals 11, 12 for electrical connection with corresponding conductors of an electric line 100, which is advantageously intended to electrically connect first and second grid portions 101, 102 of an electric grid.

When the switching apparatus is installed on the field, the first and second electric terminals 11, 12 are electrically connected to the first and second grid portions 101, 102 through corresponding sections of the electric line 100, respectively.

In operation, the flow of electric power along the electric line 100 may be directed from the first grid portion 101 to the second grid portion 102. In this case, the first and second electric terminals 11, 12 are electrically connected to a power source section and to a load section of the electric line 100, respectively.

As an alternative, the flow of electric power along the electric line 100 may be directed from the second grid portion 102 to the first grid portion 101. In this case, the first and second electric terminals 11, 12 are electrically connected to a load section and to a power source section of the electric line 100, respectively.

As a further alternative, the flow of electric power along the electric line 100 may be bidirectional as its direction depends on the momentary operating conditions of the electric grid. This may occur, for example, when both the grid portions 101, 102 include electric power generation systems (e.g. photovoltaic panels) and/or electric energy storage systems (e.g. batteries). In this case, the first and second electric terminals 11, 12 can be electrically connected, in an alternate manner, to a load section and to a power source section of the electric line 100 depending on the on-going operating conditions of the electric grid.

In the cited figures, the switching apparatus 1 includes a pair of first electric terminals 11 and a pair of second electric terminals 12. In other cases, however, the first electric terminals 11 and the second electric terminals 12 may include a different number of terminals, for example three terminals.

In the cited figures, additionally, the switching apparatus 1 includes first electric terminals 11 and second electric terminals 12, which have a floating voltage compared to ground. In some cases, however, one of the first electric terminals 11 or one of the second electric terminals 12 can directly be referred to ground. In other cases, one of the first electric terminals 11 and/or one of the second electric terminals 12 can be electrically connected to ground, e.g., through a resistor. According to further alternatives, grounding arrangements through capacitors or diode networks can be adopted.

The switching apparatus 1 is configured to allow or interrupt a current flow along the electric line 100. To this aim, the switching apparatus 1 comprises one or more primary switching devices 3.

The primary switching devices 3 are configured to switch reversibly between a conduction state, at which they conduct a current along a conductive path between the first and second electric terminals 11, 12, and an interdiction state, at which they block a current flowing along a conductive path between the first and second electric terminals 11, 12.

The primary switching devices 3 can switch reversibly among the above-mentioned interdiction and conduction states upon receiving suitable input control signals.

When the primary switching devices 3 are in a conduction state, the switching apparatus 1 results in a closed state A, at which it allows a current flow along the electric line 100.

When the primary switching devices 3 are in an interdiction state, the switching apparatus 1 results in an open state B, at which it blocks a current flow along the electric line 100.

A transition of the primary switching devices 3 from a conduction state to an interdiction state forms an opening manoeuvre of the switching apparatus while a transition of the primary switching devices 3 from an interdiction state to a conduction state forms a closing manoeuvre of the switching apparatus.

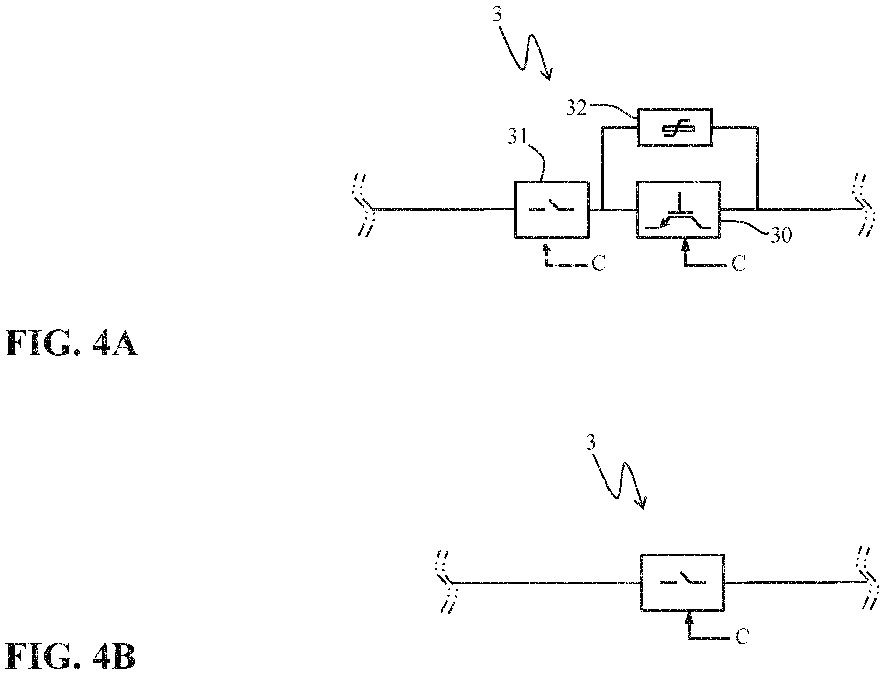

According to some embodiments of the invention (figure 4A), the primary switching devices 3 are of the solid-state type. They thus include one or more switches 30 based on semiconductor materials.

In general, the semiconductor switches 30 may be of conventional type, such as, for example, Power MOSFETs, JFETs, Insulated Gate Bipolar Transistors ("IGBTs"), Gate Turn-Off Thyristors (GTOs), Integrated Gate-Commutated Thyristors ("IGCTs"), or the like.

Upon receiving suitable input control signals, each semiconductor switch 30 can switch reversibly between an on-state, at which it conducts a current, and an off-state, at which it blocks a current.

Each semiconductor switch 30 is turned off when it switches from a conduction state to an interdiction state, and it is turned on when it switches from an interdiction state to a conduction state.

Preferably, each primary switching device 3 includes at least a pair of semiconductor switches 30 arranged according to an anti-parallel or anti-series configuration to allow a control of bidirectional currents flowing along a conductive path between the first and second electric terminals 11, 12.

Preferably, each primary switching device 3 includes a protection circuit 32 electrically connected in parallel to the one or more semiconductor switches 30. Such a protection circuit is configured to protect the associated semiconductor switches (e.g. by limiting voltage transients) when these latter are turned off during an opening manoeuvre of the switching apparatus and/or to dissipate electric energy, whenever necessary.

The protection circuit 32 can advantageously include one or more Metal-Oxide Varistors, snubbers, spark gaps, discharge tubes, and the like.

Preferably, each primary switching device 3 includes an electromechanical switch 31 electrically connected in series to the semiconductor-based switches 30.

The electromechanical switch 31 has one or more fixed contacts and one or more movable contacts. These latter can be coupled to or uncoupled from said fixed contacts to conduct or block a current.

The electromechanical switch 31 is in a closed state when its electric contacts are mutually coupled to conduct a current while it is in an open state when its electric contacts are uncoupled to block a current.

The electromechanical switch 31 can be of self-acting type. In this case, a transition from a closed state to an open state occurs by exploiting electrodynamic forces generated by the circulation of current to move the movable contacts or trip the motion of said movable contacts. The reverse transition from an open state to a closed state may instead occur upon receiving suitable input control signals, which cause the activation of a driving mechanism moving the movable contacts or tripping the motion of said movable contacts.

As an alternative, the electromechanical switch 31 can be of fully controllable type. In this case, any reversible transition between a closed state and an open state occurs in response to receiving suitable input control signals, which cause the activation of a driving mechanism moving the movable contacts or tripping the motion of said movable contacts.

As mentioned above, the primary switching devices 3 are configured to switch reversibly between a conduction state, at which they conduct a current along a conductive path between the first and second electric terminals 11, 12, and an interdiction state, at which they block a current flowing along a conductive path between the first and second electric terminals 11, 12. The primary switching devices 3 are in a conduction state, when the corresponding one or more semiconductor switches 30 (and possibly the electromechanical switch 31) are operated in such a way to allow a current flow between the first and second electric terminals 11, 12, and are in an interdiction state, when the corresponding one or more semiconductor switches 30 (and possibly the electromechanical switch 31) are operated in such a way to block a current flow between the first and second electric terminals 11, 12.

According to other embodiments of the invention (figure 4B), the primary switching devices 3 are of the electromechanical type.

Each electromechanical switching device 3 has one or more fixed contacts and one or more movable contacts that can be coupled to or uncoupled from said fixed contacts to conduct or block a current.

Each switching device 3 is in a closed state (which corresponds to a conduction state of said switching device) when its electric contacts are mutually coupled to conduct a current, whereas it is in an open state (which corresponds to an interdiction state of said switching device) when its electric contacts are mutually uncoupled to block a current.

Advantageously, each electromechanical switching device 3 is of controllable type. In this case, any reversible transition between a closed state and an open state occurs in response to receiving suitable input control signals, which cause the activation of a driving mechanism moving the movable contacts or tripping the motion of said movable contacts.

In general, the primary switching devices 3 of the switching apparatus may be realized at industrial level according to solutions of known type. Therefore, they will be described in the following only in relation to the aspects of interest for the invention.

The above-mentioned first switching arrangement can include further electronic devices or circuits to carry out the requested functionalities. These possible additional electric devices or circuits are here not described for the sake of brevity.

The switching apparatus 1 comprises a control stage 2 including a control unit 20 configured to control the operation of one or more controllable components of the switching apparatus. The controllable components of the switching apparatus may be of various type, for example electronic devices, electro-mechanical devices, or the like.

As it is apparent from the above, the above-mentioned controllable components include the primary switching devices 3 of the switching apparatus. The control unit 20 can thus control the operation of the above-mentioned primary switching devices 3, for example their reversible transitions between a conduction state and an interdiction state.

Preferably, the control unit 20 is configured to process data/information according to suitable algorithms and provide suitable control signals C to the above-mentioned controllable components of the switching apparatus.

Preferably, the control unit 20 can communicate (in a known manner) with one or more sensors (not shown) installed onboard the switching apparatus or along the electric line 100 to receive data signals related to the behaviour of currents, voltages and/or other physical quantities.

Preferably, the control unit 20 can communicate (in a known manner) with a local control device (not shown) installed in the electric grid, for example a protection relay, and/or with a remote-control device (not shown), for example a cloud computing system, to exchange data signals and/or control signals with these outer control devices.

Preferably, the control unit 20 comprises suitable digital processing devices (e.g. one or more microprocessors) adapted to execute software instructions to carry out the requested functionalities.

Preferably, the control stage 2 comprises an auxiliary storage circuit 21 (which may include one or more storage capacitors) electrically connected to the control unit 20. Advantageously, the auxiliary storage circuit 21 is continuously charged during the normal operation of the control stage and it may be used to feed the control unit 20 for a certain time, when the control stage 2 cannot be fed anymore for any reasons.

In addition to the above-mentioned components, the control stage 2 can include further electronic devices or circuits either of digital or analogic type, to carry out the requested functionalities. These possible additional electric devices or circuits are here not described for the sake of brevity.

Preferably, the switching apparatus 1 comprises a power supply stage 4 electrically connected to the control stage 2 to feed this latter with electric power drawn from the electric line 100. Preferably, the power supply stage 4 comprises input terminals 4A, at which it can be electrically connected to the first electric terminals 11 or the second electric terminals 12 of the switching apparatus as it will be more apparent from the following.

Preferably, the power supply stage 4 comprises output terminals 4B, at which it is electrically connected to the control stage 2 to feed this latter.

In the cited figures, the power supply stage 4 includes a pair of input terminals 4A and a pair of output terminals 4B, which have a floating voltage compared to ground. In some cases, however, one of the input terminals 4A and one of the output terminals 4B can be referred to ground.

Preferably, the power supply stage 4 comprises an input storage circuit 41 and a DC/DC converter 42 electrically connected in cascade between the above-mentioned input and output terminals 4A, 4B.

Preferably, the DC/DC converter is of the galvanically isolated type. In some cases, however, a DC/DC converter without galvanic isolation can be used as well.

Preferably, the input storage circuit 41 includes one or more input capacitors.

Preferably, the DC/DC converter 42 includes a switching converter of the Buck type or with another suitable configuration.

Preferably, the DC/DC converter 42 is configured to interact with the control unit 20 to operate. The power supply stage 4 can include further electronic devices or circuits either of digital or analogic type, to carry out the requested functionalities. These possible additional electric devices or circuits are here not described for the sake of brevity.

In general, the control stage 2 and the power supply stage 4 of the switching apparatus may be realized at industrial level according to solutions of known type. Therefore, they will be described in the following only in relation to the aspects of interest for the invention.

According to the invention, the switching apparatus 1 comprises a secondary switching arrangement including one or more secondary switching devices 5 controllable by the control unit 20.

The secondary switching devices 5 are electrically connected to the first and second electric terminals 11, 12 of the switching apparatus and to the power supply stage 4, namely to the input terminals 4A of this latter.

The secondary switching devices 5 are configured to switch reversibly between a first switching condition S 1 and a second switching condition S2 upon receiving suitable input control signals from the control unit 20.

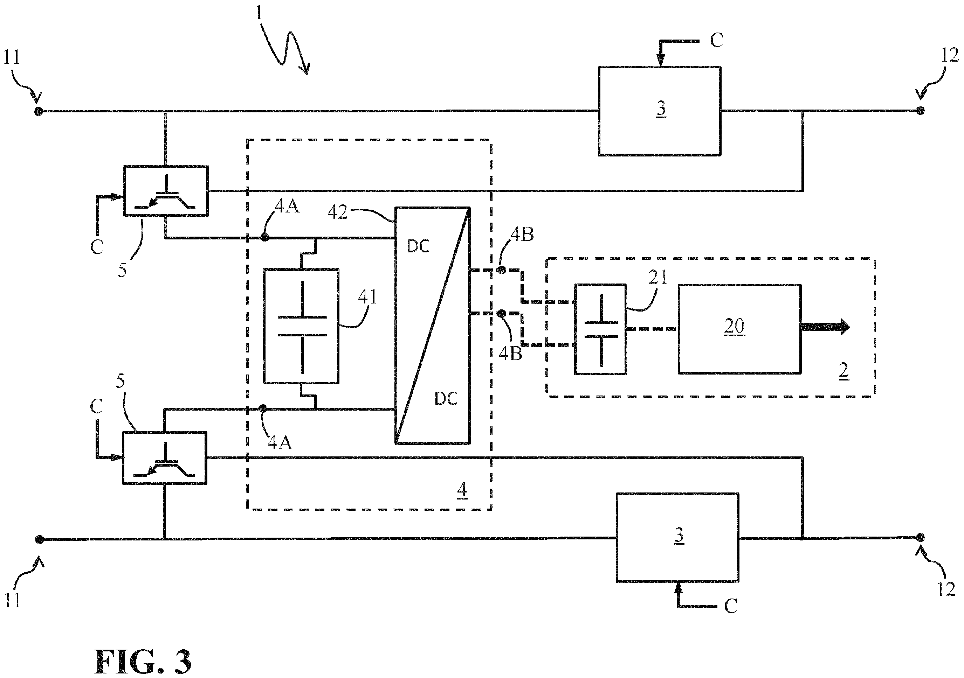

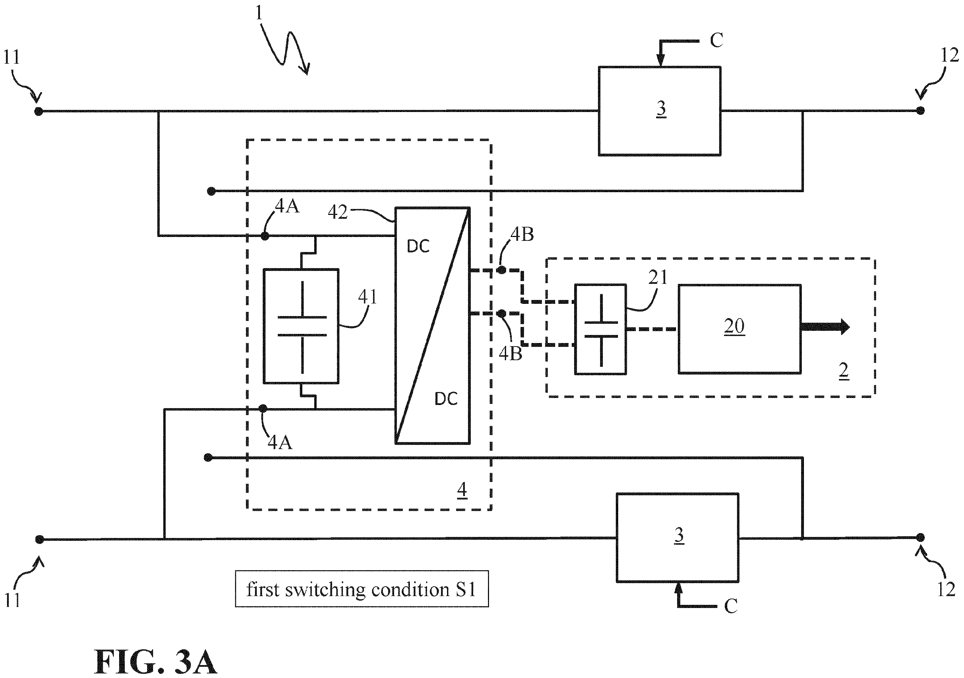

When they are in the first switching condition S 1, the secondary switching devices 5 electrically connect the first electric terminals 11 of the switching apparatus to the power supply stage 4 and electrically disconnect the second electric terminals 12 of the switching apparatus from the power supply stage 4 (figure 3A).

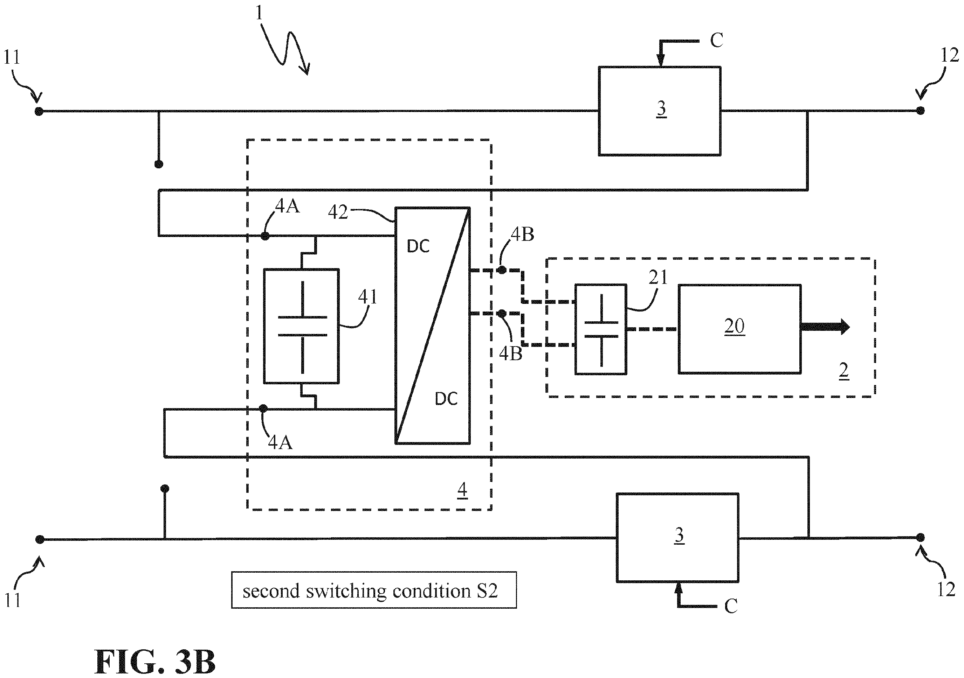

When they are in the second switching condition S2, the secondary switching devices 5 electrically connect the second electric terminals 12 of the switching apparatus to the power supply stage 4 and electrically disconnect the first electric terminals 11 of the switching apparatus from the power supply stage 4 (figure 3B).

As it is apparent from the above, the secondary switching devices 5 can electrically connect the power supply stage 4 to the first electric terminals 11 or to the second electric terminals 12 in an alternate manner, upon receiving suitable input control signals from the control unit 20. The power supply stage 4 can thus be electrically connected to a power source side or to a load side of the electric line 100 according to the needs.

As it will be more apparent from the following, this solution allows preventing damages to the power supply stage 4 during an opening manoeuvre of the switching apparatus and, at the same time, ensuring optimal performances and interruption ratings for the switching apparatus, particularly in case of electric faults, for example short-circuits.

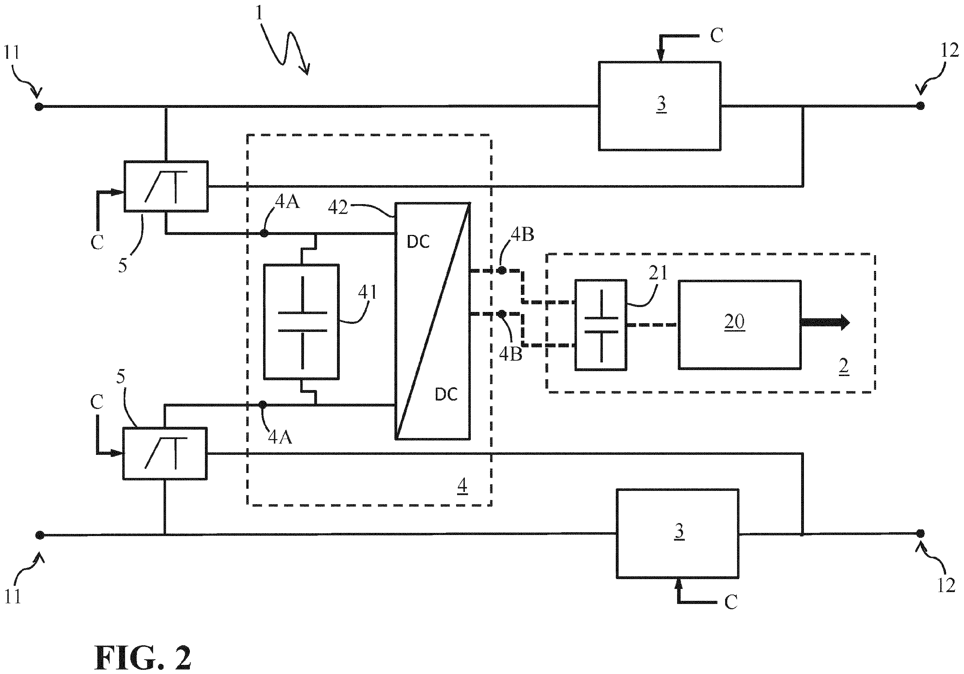

According to some embodiments of the invention (figure 2), the secondary switching devices 5 are of electromechanical type. As an example, each secondary switching device 5 can be formed by an electromechanical relay having multiple electric contacts that can be coupled or decoupled upon receiving suitable input control signals.

The electromechanical relay 5 is in the first switching condition S1, when the corresponding electric contacts are operated in such a way to electrically connect the first electric terminals 11 of the switching apparatus to the power supply stage 4 and electrically disconnect the second electric terminals 12 of the switching apparatus from the power supply stage 4 (figure 3A).

The electromechanical relay 5 is in the second switching condition S2, when the corresponding electric contacts are operated in such a way to electrically disconnect the first electric terminals 11 of the switching apparatus from the power supply stage 4 and electrically connect the second electric terminals 12 of the switching apparatus to the power supply stage 4 (figure 3B).

According to other embodiments of the invention (figure 3), the secondary switching devices 5 are of solid-state type, each including one or more switches based on semiconductor materials.

As an example, each secondary switching device 5 can include a switching circuit including a plurality of semiconductor switches capable of reversibly switching between an on-state and an off-state upon receiving suitable input control signals.

The secondary switching devices 5 are in the first switching condition S1, when the corresponding one or more semiconductor switches are operated in such a way to electrically connect the first electric terminals 11 of the switching apparatus to the power supply stage 4 and electrically disconnect the second electric terminals 12 of the switching apparatus from the power supply stage 4 (figure 3A).

The secondary switching devices 5 are in the second switching condition S2, when the corresponding one or more semiconductor switches are operated in such a way to electrically disconnect the first electric terminals 11 of the switching apparatus from the power supply stage 4 and electrically connect the second electric terminals 12 of the switching apparatus to the power supply stage 4 (figure 3B).

Preferably, each secondary switching device 5 can include a protection circuit (not shown) electrically connected in parallel to the one or more semiconductor switches. Such a protection circuit can advantageously include one or more Metal-Oxide Varistors, snubbers, spark gaps, discharge tubes, and the like.

According to other embodiments of the invention (not shown), the secondary switching devices 5 are of hybrid type. In this case, each secondary switching device includes one or more switches based on semiconductor materials and one or more electromechanical switches.

In general, the secondary switching devices 5 of the switching apparatus may be realized at industrial level according to solutions of known type. Therefore, they will be described in the following only in relation to the aspects of interest for the invention.

The above-mentioned second switching arrangement can include further electronic devices or circuits to carry out the requested functionalities.

For example, it may include a diode arranged in series to each secondary switching device 5 such a way to prevent a reverse current to flow through the switching apparatus, thereby preventing the discharge of the storage circuit 41.

Possible additional electric devices or circuits are here not described for the sake of brevity.

According to an aspect of the invention, the control unit 20 is configured to command the secondary switching devices 5 to operate in the above-mentioned first switching condition S1 or in the above-mentioned second switching condition S2 or to switch reversibly between the above-mentioned first and second switching conditions S1, S2 depending on the operating state of the switching apparatus (and therefore depending on the operating state of the primary switching devices 3).

Preferably, the control unit 20 is configured to command the secondary switching devices 5 to operate in the above-mentioned first switching condition or in said second switching condition, when the switching apparatus operates in a closed state A or in an open state B.

The control unit 20 is configured to select the switching condition S1 or S2 for the secondary switching devices 5 depending on the direction of the power flow along the electric line 100 and the state of the switching apparatus.

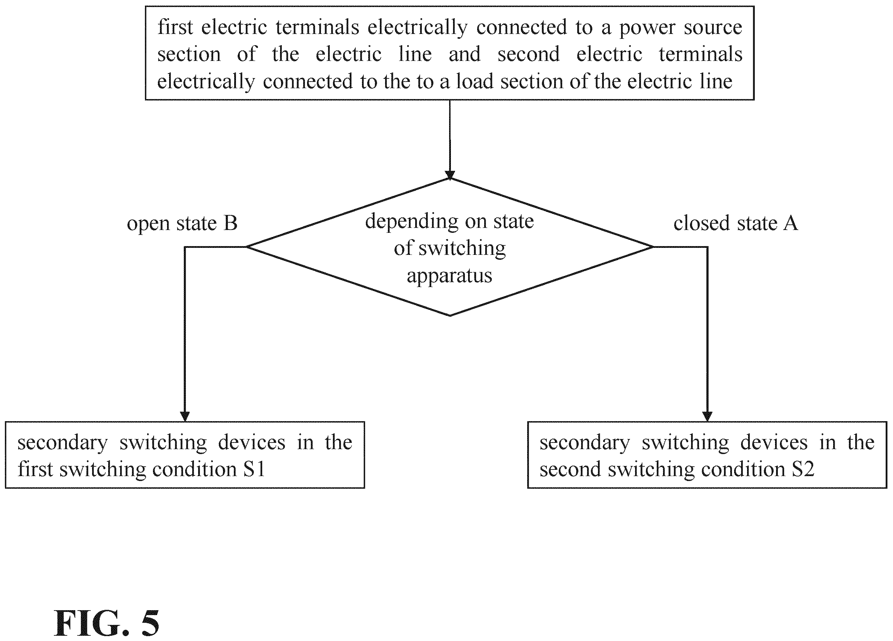

If the first electric terminals 11 are electrically connected to a power source section of the electric line and the second electric terminals 12 are electrically connected to a load section of the electric line (the electric power flows along the electric line according to a direction going from the first electric terminals 11 to the second electric terminals 12), the control unit 20 commands the secondary switching devices 5 to operate in the above-mentioned first switching condition S1, when the switching apparatus is in an open state B, and commands the secondary switching devices 5 to operate in the above-mentioned second switching condition S2, when the switching apparatus is in a closed state A (figure 5).

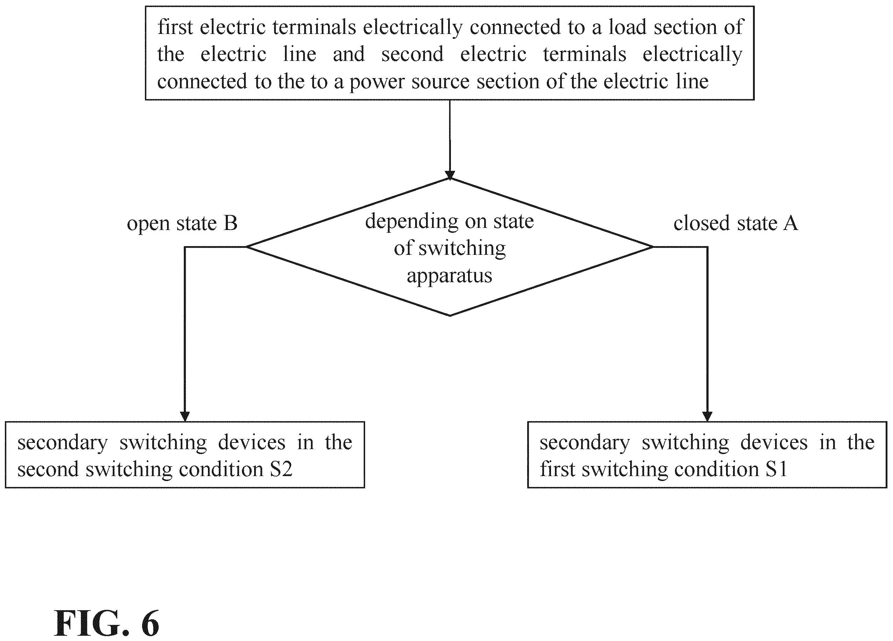

If the first electric terminals 11 are electrically connected to a load section of the electric line and the second electric terminals 12 are electrically connected to a power source section of the electric line (the electric power flows along the electric line according to a direction going from the second electric terminals 12 to the first electric terminals 11), the control unit 20 commands the secondary switching devices 5 to operate in the above-mentioned second switching condition S2, when the switching apparatus is in an open state B, and commands the secondary switching devices 5 to operate in the above-mentioned first switching condition S1, when the switching apparatus is in a closed state A (figure 6).

When the flow of electric power changes its direction depending on the momentary operating conditions of the electric grid, the control unit 20 can dynamically change the control logic of the switching devices 5 according to the needs.

As an example, the control unit 20 can determine the direction of the power flow along the electric line 100 based on suitable detection signals received by suitable sensors arranged onboard the switching apparatus or along the electric line 100 and command the switching devices 5 by dynamically selecting the most appropriate control logic.

Preferably, the control unit 20 is configured to command the secondary switching devices 5 to switch reversibly between the above-mentioned first and second switching conditions S1, S2 during an opening manoeuvre or a closing manoeuvre of said switching apparatus.

The control unit 20 is configured to select the switching operations for the secondary switching devices 5 depending on the direction of the power flow along the electric line 100 and the state of the switching apparatus.

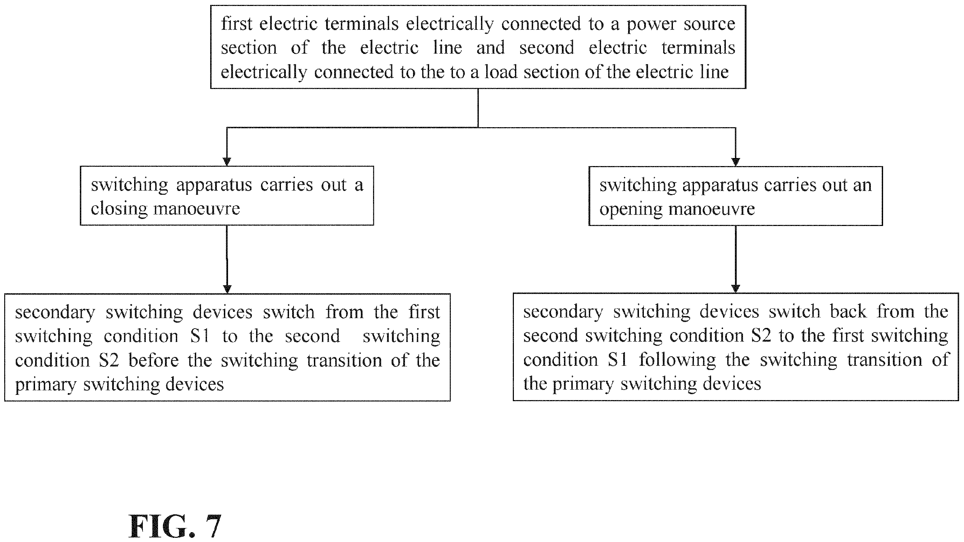

Referring to figure 7, if the first electric terminals 11 are electrically connected to a power source section of the electric line and the second electric terminals 12 are electrically connected to a load section of the electric line (the electric power flows along the electric line according to a direction going from the first electric terminals 11 to the second electric terminals 12), the control unit 20 commands the secondary switching devices 5 to:
- switch from the above-mentioned first switching condition S1 to the above-mentioned second switching condition S2, before the primary switching devices 3 carry out a switching transition corresponding to a closing manoeuvre (in practice before the primary switching devices 3 switch from the interdiction state to the conduction state);
- switch back from the above-mentioned second switching condition S2 to the above-mentioned first switching condition S1, when the primary switching devices 3 have completed a switching transition corresponding to an opening manoeuvre (in practice after the primary switching devices 3 switch from the conduction state to the interdiction state).

Obviously, the switch timing between the switching conditions S1, S2 must be carefully tuned to avoid the simultaneous connection of the supply stage 4 to both terminals 11 and 12, in order to prevent a bypass to the main breaker.

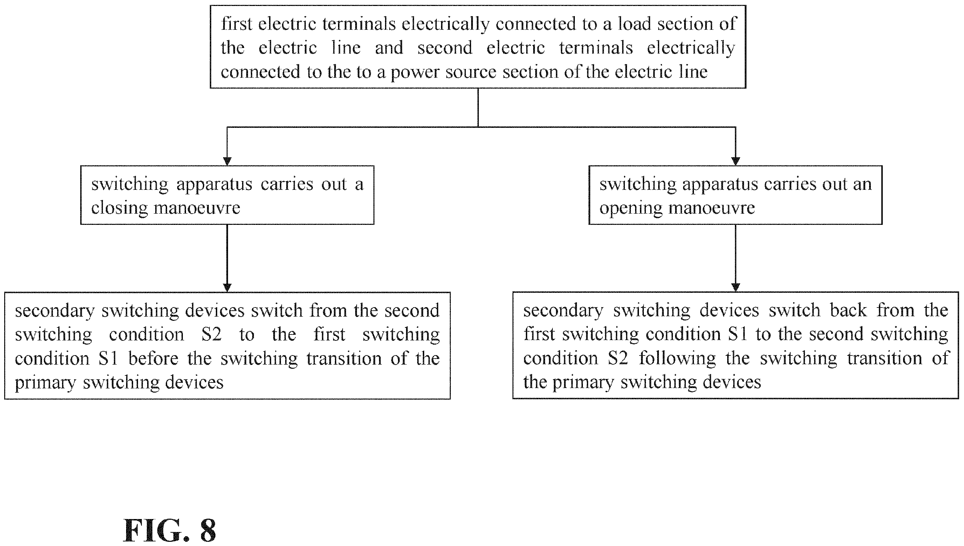

Referring to figure 8, if the first electric terminals 11 are electrically connected to a load section of the electric line and the second electric terminals 12 are electrically connected to a power source section of the electric line (the electric power flows along the electric line according to a direction going from the second electric terminals 12 to the first electric terminals 11), the control unit 20 commands the secondary switching devices 5 to:
- switch from the above-mentioned second switching condition S2 to the above-mentioned first switching condition S1, before the primary switching devices 3 carry out a switching transition corresponding to a closing manoeuvre (in practice before the primary switching devices 3 switch from the interdiction state to the conduction state);
- switch back from the above-mentioned first switching condition S1 to the above-mentioned second switching condition S2, when the primary switching devices 3 have completed a switching transition corresponding to an opening manoeuvre (in practice after the primary switching devices 3 switch from the conduction state to the interdiction state).

When the flow of electric power changes its direction depending on the momentary operating conditions of the electric grid, the control unit 20 can dynamically change the control logic of the secondary switching devices 5, as explained above.

The behaviour of the switching apparatus, according to the invention, is now described in more details with reference to some specific operating conditions.

In the following discussion, it is supposed that the first and second electric terminals 11, 12 of the switching apparatus are electrically connected respectively to a power source section and load section of the electric line (the electric power flows according to a direction going from the first electric terminals 11 to the second electric terminals 12).

### Closed state of the switching apparatus (normal condition)

When the switching apparatus is in a closed state A, the primary switching devices 3 operate in a conduction condition and a current flows along the electric line.

The control unit 20 commands the secondary switching devices 5 to continue to operate in the second switching condition S2 (figure 5).

The power supply stage 4 is thus electrically connected to the second electric terminals 12, i.e., to the load section of the electric line, and it is electrically disconnected from the first electric terminals 11.

An opening manoeuvre of the switching apparatus can be carried out at any time.

### Opening manoeuvre of the switching apparatus

The switching apparatus is now supposed to have to carry out an opening manoeuvre, for example to interrupt a nominal current or an overload current or a short-circuit current along the electric line.

The power supply stage 4 is electrically connected to the second electric terminals 12 and it is electrically disconnected from the first electric terminals 11, i.e., it is connected to the load section of the electric line.

The control unit 20 commands the primary switching devices 3 to switch from a conduction state to an interdiction state.

As the power supply stage 4 is electrically connected to the second electric terminals 12 (i.e., downstream the primary switching devices 3 referring to the power flow direction along the electric line) and it is electrically disconnected from the first electric terminals 11 (i.e., upstream the primary switching devices 3), possible currents towards the power supply stage 4 are interrupted by the primary switching devices 3 themselves since the latter switch to an interdiction state. The power supply stage 4 is thus not affected by in-rush currents.

Once the switching transition of the primary switching devices 3 is completed, the control unit 20 commands the secondary switching devices 5 to switch from the second switching condition S2 to the first switching condition S1 (figure 7).

Even if it cannot be fed by electric power drawn by the electric line, the control unit 20 can still operate as it can exploit the electric energy stored in the energy storage circuit 41 of the power supply stage 4 and/or by the auxiliary storage circuit 21.

Once the reverse switching transition of the secondary switching devices 5 is completed, the power supply stage 4 is electrically connected to the first electric terminals 11, i.e., to the power source section of the electric line, and it is electrically disconnected from the second electric terminals 12.

A closing manoeuvre of the switching apparatus can be carried out at any time, even if the primary switching devices 3 are in an interdiction state and no current flows along the electric line.

### Open state of the switching apparatus

When the switching apparatus is in an open state B, the primary switching devices 3 are in an interdiction state and no current flows along the electric line.

The control unit commands the secondary switching devices 5 to continue to operate in the first switching condition S1 (figure 5).

The power supply stage 4 is thus electrically connected to the first electric terminals 11, i.e., to the power source section of the electric line, and it is electrically disconnected from the second electric terminals 12.

A closing manoeuvre of the switching apparatus can be carried out at any time, even if the primary switching devices 3 are in an interdiction state and no current flows along the electric line.

### Closing manoeuvre of the switching apparatus

The switching apparatus is now supposed to have to carry out a closing manoeuvre.

The control unit 20 initially commands the secondary switching devices 5 to switch from the first switching condition S1 to the second switching condition S2 (figure 7).

The power supply stage 4 is thus electrically connected to the second electric terminals 12, i.e., to the load section of the electric line.

Once the switching transition of the secondary switching devices 5 is completed, the control unit 20 commands the primary switching devices 3 to switch from an interdiction state to a conduction state.

If no electric faults arise during the closing manoeuvre of the switching apparatus, once the switching transition of the primary switching devices 3 is completed, the control unit 20 commands the secondary switching devices 5 to remain in the second switching condition S2 (figure 7).

An opening manoeuvre of the switching apparatus can be carried out at any time.

If an electric fault (e.g., a short circuit) arises during the closing manoeuvre of the switching apparatus (making current on a fault), the control unit 20 immediately commands the primary switching devices 3 to switch back to an interdiction state (the secondary switching devices 5 do not play any role in this case).

Once the switching transition of the primary switching devices 3 is completed, the control unit 20 commands the secondary switching devices 5 to switch back from the second switching condition S2 to the first switching condition S1 (figure 7).

Also in this case, the control unit 20 can still operate as it can exploit the electric energy stored in the energy storage circuit 41 of the power supply stage 4 and/or by the auxiliary storage circuit 21.

Once the switching transition of the secondary switching devices 5 is completed, the power supply stage 4 is again electrically connected to the first electric terminals 11, i.e., to the power source section of the electric line, and it is electrically disconnected from the second electric terminals 12.

A closing manoeuvre of the switching apparatus can be carried out at any time (once the electric fault is cleared), even if the primary switching devices 3 are in an interdiction state and no current flows along the electric line.

The behaviour of the switching apparatus, according to the invention, is substantially the same if the first and second electric terminals 11, 12 of the switching apparatus are electrically connected respectively to a load section and to a power source section of the electric line (the electric power flows according to a direction going from the second electric terminals 12 to the first electric terminals 11). In this case, however, the control unit will adopt inverted control logics (figure 6 and 8) of the switching transitions by the secondary switching devices 5 compared to the control logics illustrated above.

When the flow of electric power along the electric line changes its direction depending on the momentary operating conditions of the electric grid, the control unit 20 can dynamically change the selection logic of the switching transitions by the secondary switching devices 5 once the direction of the power flow is determined.

The switching apparatus, according to the invention, offers relevant advantages compared to similar electric systems of the state of the art.

By virtue of the above-described secondary switching arrangement, the power supply stage of the switching apparatus can be electrically connected to the load section of the electric line (i.e., downstream the primary switching devices intended to interrupt a current along the electric line) or to power source section of the electric line (i.e., upstream the primary switching devices intended to interrupt a current along the electric line) in an alternate manner and depending on the operating conditions of the switching apparatus.

By properly coordinating the switching transitions of the primary and secondary switching devices of the switching apparatus, this allows preventing the flow of in-rush currents through the power supply stage during an opening manoeuvre of the switching apparatus and during a closing manoeuvre of the switching apparatus (when a fault occurs). At the same time, it is possible to suitably feed the control stage of the switching apparatus whenever necessary.

As it has no more to withstand the flow of in-rush currents, the power supply stage of the switching apparatus may be designed in such a way to include a relatively small input capacitance and a reduced set of protection arrangements.

The power supply stage of the switching apparatus can thus have a very compact structure and result quite cheap to manufacture at industrial level.

On the other hand, the arrangement of the smaller input capacitance in the power supply stage allows improving the interruption ratings of the primary switching devices of the switching apparatus, particularly when these latter are of the solid-state type.

The switching apparatus, according to the invention, can ensure high-level performances and, at the same time, be relatively easy and cheap to manufacture at industrial level.

## Claims

1. A switching apparatus (1) for DC electric grids comprising:
- first and second electric terminals (11, 12) for electrical connection with corresponding conductors of an electric line (100);
- a primary switching arrangement including one or more primary switching devices (3), said primary switching devices being configured to switch reversibly between a conduction state, at which said primary switching devices conduct a current between said first and second electric terminals (11, 12), and an interdiction state, at which said primary switching devices block a current flowing between said first and second electric terminals (11, 12);
- a control stage (2) including a control unit (20) configured to control one or more controllable components (30, 31, 32, 5, 42) of said switching apparatus;
- a power supply stage (4) electrically connected to said control stage (2) to feed said control stage (2) with electric power drawn from said electric line (100);
**characterised in that** it comprises a secondary switching arrangement including one or more secondary switching devices (5) controllable by said control unit (20), said secondary switching devices being configured to switch reversibly between a first switching condition (S1), at which said secondary switching devices electrically connect said first electric terminals (11) to said power supply stage (4) and electrically disconnect said second electric terminals (12) from said power supply stage (4), and a second switching condition (S2), at which said secondary switching devices electrically disconnect said first electric terminals (11) from said power supply stage (4) and electrically connect said second electric terminals (12) to said power supply stage (4).

2. Switching apparatus, according to claim 1, **characterised in that** said control unit (20) is configured to command said secondary switching devices (5) to operate depending on the operating state of the switching apparatus.

3. Switching apparatus, according to claim 2, **characterised in that** said control unit (20) is configured to:
- command said secondary switching devices (5) to operate in said first switching condition (S1), when said switching apparatus is in an open state (B); and
- command said secondary switching devices (5) to operate in said second switching condition (S2), when said switching apparatus is in a closed state (A);
if said first electric terminals (11) are electrically connected to a power source section of said electric line (100) and said second electric terminals (12) are electrically connected to a load section of said electric line.

4. Switching apparatus, according to claim 2, **characterised in that** said control unit (20) is configured to:
- command said secondary switching devices (5) to operate in said second switching condition (S2), when said switching apparatus is in an open state (B);
- command said secondary switching devices (5) to operate in said first switching condition (S1), when said switching apparatus is in a closed state (A);
if said first electric terminals (11) are electrically connected to a load section of said electric line (100) and said second electric terminals (12) are electrically connected to a power source section of said electric line.

5. Switching apparatus, according to claim 2, **characterised in that** said control unit (20) is configured to command said secondary switching devices (5) to switch reversibly between said first switching condition (S1) and said second switching condition (S2) during an opening manoeuvre or a closing manoeuvre of said switching apparatus.

6. Switching apparatus, according to claim 5, **characterised in that** said control unit (20) is configured to command said secondary switching devices (5) to:
- switch from said first switching condition (S 1) to said second switching condition (S2), before said primary switching devices (3) carry out a switching transition corresponding to a closing manoeuvre;
- switch back from said second switching condition (S2) to said first switching condition (S1), when said primary switching devices (3) have completed the switching transition corresponding to an opening manoeuvre;
if said first electric terminals (11) are electrically connected to a power source section of said electric line (100) and said second electric terminals (12) are electrically connected to a load section of said electric line.

7. Switching apparatus, according to claim 5, **characterised in that** said control unit (20) is configured to command said secondary switching devices (5) to:
- switch from said second switching condition (S2) to said first switching condition (S1), before said primary switching devices (3) carry out a switching transition corresponding to a closing manoeuvre;
- switch back from said first switching condition (S 1) to said second switching condition (S2), when said primary switching devices (3) have completed a switching transition corresponding to an opening manoeuvre,
if said first electric terminals (11) are electrically connected to a load section of said electric line (100) and said second electric terminals (12) are electrically connected to a power source section of said electric line.

8. Switching apparatus, according to one of the previous claims, **characterised in that** said one or more primary switching devices (3) are of solid-state type, each including one or more switches (30) based on semiconductor materials.

9. Switching apparatus, according to one of the claims from 1 to 7, **characterised in that** said one or more primary switching devices (3) are of electromechanical type.

10. Switching apparatus, according to one of the previous claims, **characterised in that** said secondary switching devices (5) are of electromechanical type.

11. Switching apparatus, according to one of the claims from 1 to 9, **characterised in that** said secondary switching devices (5) are of solid-state type, each including one or more switches based on semiconductor materials.

12. Switching apparatus, according to one of the claims from 1 to 9, **characterised in that** said secondary switching devices (5) are of hybrid type, each including one or more switches based on semiconductor materials and one or more electromechanical switches.

13. A DC electric grid comprising at least a switching apparatus (1), according to one of the previous claims.
